# EUROPÄISCHE PATENTSCHRIFT

(11) **EP 1 347 242 B1**
(45) Veröffentlichungstag und Bekanntmachung des Hinweises auf die Patenterteilung: **09.07.2008**
(21) Anmeldenummer: 03005582.6
(22) Anmeldetag: 12.03.2003
(51) Int. Cl.: F24C 3/08, F24C 7/08, F24C 3/06

(54) **Bedienvorrichtung für ein Elektrogerät**
Operating device for an electrical appliance
Disposif de commande d'un appareil électrique

(30) Priorität: 19.03.2002 DE 10212929
(43) Veröffentlichungstag der Anmeldung: 24.09.2003
(73) Patentinhaber: E.G.O. ELEKTRO-GERÄTEBAU GmbH, D-75038 Oberderdingen (DE)
(72) Erfinder: Schilling, Wilfried, 76703 Kraichtal (DE)
(74) Vertreter: Patentanwälte Ruff, Wilhelm, Beier, Dauster & Partner

(56) Entgegenhaltungen:
- DE-A1- 19 612 422
- US-A- 4 812 804
- US-B1- 6 498 326

## Beschreibung

### Anwendungsgebiet und Stand der Technik

Die Erfindung betrifft eine Bedienvorrichtung für ein Elektrogerät, wobei dies vorzugsweise ein Elektrowärmegerät wie beispielsweise ein Kochfeld ist.

Aus der DE 198 59 105 beispielsweise ist eine Bedienvorrichtung für ein Elektrogerät bekannt mit einer Art magnetischer Schiebetaster. Der Schiebetaster ist dabei auf einer Glaskeramikplatte eines Kochfeldes aufgelegt und weist eine magnetische Führung auf. Durch sogenanntes Tasten, also lineare Bewegungen in verschiedene, insbesondere entgegengesetzte, Richtungen ist das Auslösen von Schaltsignalen möglich und damit die Bedienung des Elektrogerätes. Hierbei ist jedoch nur eine begrenzte Anzahl von Bedienfunktionen möglich.

### Aufgabe und Lösung

Der Erfindung liegt die Aufgabe zugrunde, eine eingangs genannte Bedienvorrichtung für ein Elektrogerät zu schaffen, mit der die Funktionalitäten der Bedienung erweitert werden können.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß weist die Bedienvorrichtung, die insbesondere die gesamte Bedienung zumindest einer Funktionseinheit des Elektrogerätes beinhalten kann, eine Bedieneinheit mit einem Drehknebel auf. Ein Drehknebel weist den Vorteil auf, dass radiale Stellsignale sehr gut unterschieden werden können. Beim Erzeugen eines Stellsignals in Abhängigkeit einer bestimmten Drehung kann bei mehrfachen Drehungen des Drehknebels eine beliebig große Anzahl von Stellsignalen erzeugt werden.

Der Drehknebel ist dabei drehbewegbar an einer Lagervorrichtung gelagert, welche Teil der Bedienvorrichtung ist. Des weiteren sind Signalmittel vorgesehen, mit denen abhängig von einer Stellung und/oder einer Stellungsänderung des Drehknebels Signale erzeugt werden können. Zur Verarbeitung dieser Signale weist die Bedienvorrichtung eine Steuerung auf. Davon abhängig wird das Elektrogerät oder eine Funktionseinheit des Elektrogerätes beeinflusst.

Zusätzlich zu einer Drehbewegung ist der Drehknebel erfindungsgemäß in mindestens eine Richtung derart bewegbar gelagert, dass er eine Linearbewegung durchführen kann. Hierzu sind weitere Signalmittel vorgesehen, mit denen die Linearbewegung des Drehknebels erkannt und in Signale für die Steuerung umgesetzt werden können.

Somit wird ein kombinierter Dreh-Schiebe-Knebel zur Bedienung eines Elektrogerätes geschaffen. Dabei ist es beispielsweise vorteilhaft möglich, durch eine Linear- oder Schiebebewegung in eine bestimmte Richtung eine bestimmte Auswahl zu treffen, beispielsweise eine Leistungsskala. Dabei kann durch eine anschließende Drehbewegung diese Leistungsskala eingestellt werden. Ebenso ist es möglich, mittels einer Drehbewegung sozusagen durch ein Menü zu fahren oder blättern. Mit einer entsprechenden Linearbewegung kann dann in ein Untermenü gesprungen werden oder eine Auswahl oder Bestätigung vorgenommen werden.

In weiterer Ausgestaltung der Erfindung kann die Lagervorrichtung derart ausgebildet sein, dass die Bedieneinheit an einer Abdeckung des Elektrogerätes abnehmbar befestigt ist. Dazu ist eine Haltekraft vorgesehen, die vorzugsweise nicht kontaktierend ist bzw. eine Fernkraftwirkung aufweist. Vorteilhaft sind dies beispielsweise Haltemagnete, die in der Lagervorrichtung und/oder an der Abdeckung des Elektrogerätes vorgesehen sein können. Bei einer solchen Ausführung ist es möglich, die Bedieneinheit beispielsweise aus Sicherheitsgründen abzunehmen. Ebenso ist es dadurch möglich, mehrere Elektrogeräte mit derselben Bedieneinheit zu bedienen.

Die Drehbarkeit des Drehknebels kann um eine Drehachse, insbesondere eine einzige Drehachse, gegeben sein. Eine Linearbewegung erfolgt vorteilhaft im wesentlichen radial dazu. Besonders bevorzugt ist die Lagervorrichtung derart ausgebildet, dass sich der Drehknebel nach Durchführen einer Linearbewegung selbsttätig zurückstellt, also beispielsweise nach einem Loslassen. Dies bewirkt, dass der Drehknebel vor allem, insbesondere ausschließlich, in einer Stellung die Drehbetätigung durchführen kann. Dies kann vorteilhaft eine Mittel- oder Normalstellung sein.

Bei einer besonders bevorzugten Ausgestaltung der Erfindung ist nicht nur die Bedieneinheit von der Abdeckung abnehmbar ausgebildet, sondern auch zumindest der wesentliche Teil der Lagervorrichtung. Hier kann beispielsweise vorgesehen sein, dass der Drehknebel mit der Lagervorrichtung eine Baueinheit bzw. eine separate Bedieneinheit bildet. Diese kann auf verschiedene Art und Weise an eine Abdeckung oder dergleichen eines Elektrogerätes angesetzt und dort gehaltert werden. Es sind lediglich entweder die Signalmittel an der Abdeckung anzuordnen oder, falls diese auch in der Bedieneinheit vorgesehen sind, eine Signalübertragung von der Bedieneinheit an das Elektrogerät. Dies kann es ermöglichen, das Elektrogerät selber einfacher auszubilden. Die Bedienfunktionalitäten samt der Erfassung von Stellsignalen sind komplett in der Bedienvorrichtung vorhanden.

Die Lagervorrichtung kann dabei eine Art Grundplatte oder Kasten aufweisen, die an der Abdeckung befestigbar ist oder anliegt. Eine Befestigung der Grundplatte an der Abdeckung erfolgt vorzugsweise mittels Fernkraftwirkung, beispielsweise magnetisch.

In weiterer Ausgestaltung der Erfindung ist es möglich, dass der Drehknebel die Linearbewegung gegenüber einer Grundplatte oder Lagerung der Lagervorrichtung ausübt. Alternativ oder zusätzlich ist es möglich, dass der Drehknebel und die Grundplatte gegenüber der Abdeckung eine Linearbewegung durchführen können. Somit kann die Linearbewegung des Drehknebels entweder gegenüber der Grundplatte oder, zusammen mit der Grundplatte, gegenüber der Abdeckung stattfinden.

Eine Führung der Linearbewegung, insbesondere auch der Drehbewegung, kann vorteilhaft berührungsfrei mittels Fernkraftwirkung, wie beispielsweise Magnetkraft, erfolgen. Dies bewirkt, dass eine solche Führung zwar einen gewissen Aufwand bedeutet. Andererseits hat sie den Vorteil, dass sie verschleißfrei ist und beispielsweise eine geschlossene Oberfläche der Abdeckung ermöglicht. Alternativ ist es für bestimmte Ausgestaltungen der Erfindung auch möglich, eine Führung durch mechanische Führungsmittel herzustellen.

Ein Teil der Signalmittel kann vorteilhaft im Drehknebel vorgesehen sein. Dies kann eine funktionale Hälfte von Signalmitteln sein, welche aus mindestens zwei zusammenwirkenden Teilen bestehen. Hier können vorteilhaft die Signalmittel bzw. die andere funktionale Hälfte der Signalmittel an der Lagervorrichtung bzw. einer Grundplatte der Lagervorrichtung angeordnet sein. Ebenso ist es möglich, Signalmittel bzw. die andere funktionale Hälfte der Signalmittel unterhalb der Abdeckung vorzusehen. Durch diese Signalmittel können Dreh- und Linearbewegungen ermittelt werden.

In weiterer Ausgestaltung der Erfindung können in der Bedieneinheit Anzeigemittel vorgesehen sein. Mit diesen ist es möglich, optische Effekte, Betriebsparameter oder Einstellungen anzuzeigen. Hierzu können Leuchtmittel an einer Anzeige vorgesehen sein, um die Aufmerksamkeit eines Betrachters darauf zu lenken.

Bei einer Ausführungsmöglichkeit der Erfindung kann eine Anzeige in dem Drehknebel vorgesehen sein. Da dieser gegenüber dem Elektrogerät abnehmbar ist und keinerlei elektrischen Leitungen oder Verbindungen aufweisen sollte, kann eine Energieübertragung für die Anzeigemittel transformatorisch ausgebildet sein. Hierzu können entsprechende Spulen an der Abdeckung sowie dem Drehknebel oder der Lagervorrichtung vorgesehen sein.

Des weiteren können die Signalmittel Stellungsbestimmungsmittel aufweisen, mit denen eine Stellung, vorzugsweise auch die Drehwinkellage, des Drehknebels gegenüber einem Referenzpunkt oder Ruhepunkt der Abdeckung ermittelt werden kann. Dazu können sie, insbesondere als jeweils eine funktionale Hälfte der Signalmittel, mindestens einen Signalmagnet und mindestens einen Magnetfeldsensor oder Hall-Sensor aufweisen. Vorteilhaft sind mehrere Magnetfeldsensoren vorgesehen, die jeweils eine Stellungsänderung eines Signalmagneten detektieren können. Die Magnetfeldsensoren sind vorteilhaft in der Bewegungsbahn des Drehknebels bzw. der entsprechenden Signalmagnete angeordnet.

Damit eine Betätigung des Drehknebels als Linearbetätigung zwar eindeutig erkennbar ist, andererseits aber auch praxistauglich, nicht zu aufwendig und gut erfassbar ist, sollte sie bis zur Auslösung eines Signals oder bis an einen Anschlag kürzer sein als der Radius des Drehknebels bzw. die Erstreckung der Drehknebels in Richtung der Betätigung. Dadurch ist es möglich, den Mittelpunkt des Drehknebels, der vorteilhaft als der die Linearbetätigung vorgebende Punkt verwendet wird, innerhalb der Erstreckung des Drehknebels in Ruhestellung zu belassen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen:
Fig. 1 eine Draufsicht auf eine von Führungsmagneten gebildete Lagervorrichtung samt Hall-Sensoren und einer Abdeckung,
Fig. 2 eine schematische Schnittdarstellung durch einen Drehknebel mit einem Polkreuz, welches einen Zentralmagneten und außen angeordnete Signalmagnete enthält,
Fig. 3 eine Bedieneinheit bestehend aus einem Drehknebel und einer Lagervorrichtung unter einem Glaskeramikkochfeld,
Fig. 4 eine Bedieneinheit mit einem Drehknebel, der abnehmbar an einem Haltemodul gelagert ist, welches wiederum abnehmbar an einem Glaskeramikkochfeld gehaltert ist und
Fig. 5 einen beispielhaften Bewegungsbereich des Drehknebels bezüglich der Linearbewegungen.

### Detaillierte Beschreibung der Ausführungsbeispiele

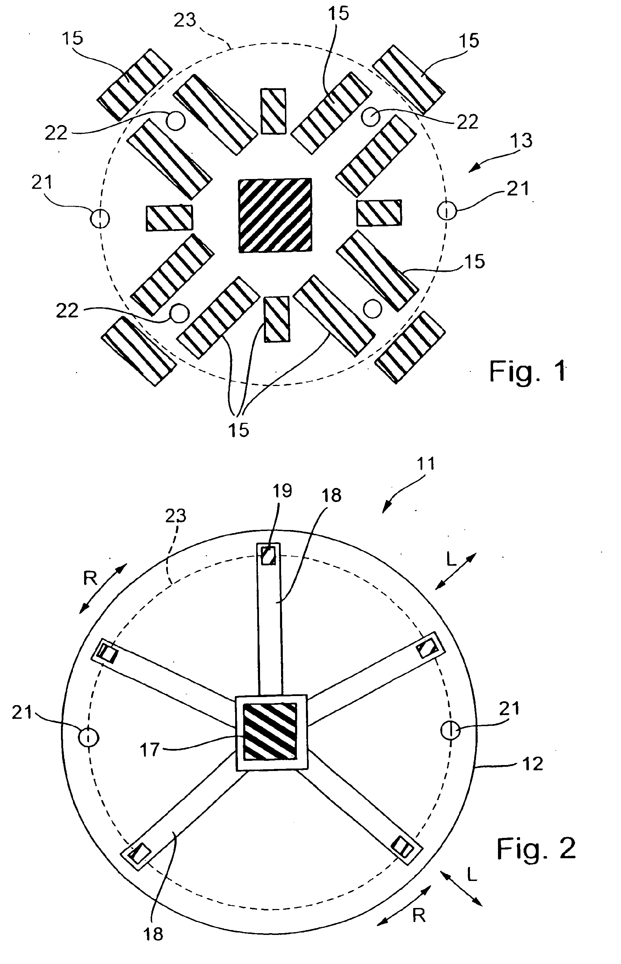

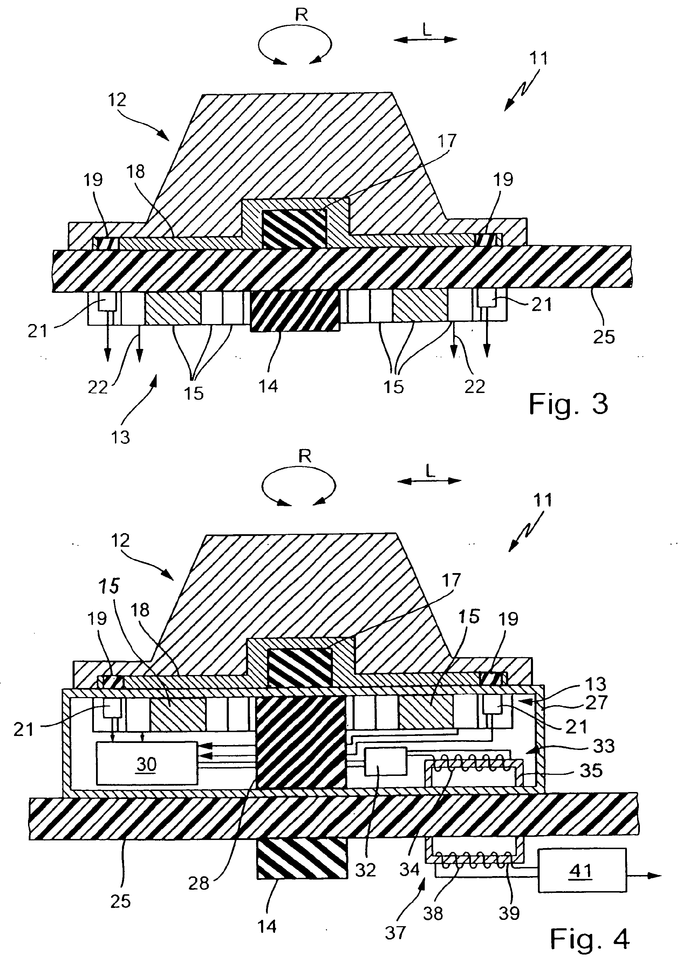

In Fig. 1 ist eine Lagervorrichtung 13 für eine Bedieneinheit 11, wie sie aus den Fig. 3 und 4 im seitlichen Schnitt hervorgeht, dargestellt. Diese Lagervorrichtung 13 kann, wie den beiden vorgenannten Figuren entnommen werden kann, entweder unter einem Glaskeramikkochfeld 25 oder in einem Haltemodul 27 unter dessen Oberseite 26 angeordnet sein.

Dabei weist die Lagervorrichtung 13 einen ersten Zentralmagneten 14 auf, der zur Zentrierung des Drehknebels 12 dient. Des weiteren sind mehrere Führungsmagnete 15 um den ersten Zentralmagneten 14 herum angeordnet. Diese bilden, wie deutlich aus Fig. 1 zu ersehen ist, eine Linearführung für den Drehknebel 12. Die Anordnung entspricht in etwa einer Führungskulisse, wie sie auch gemäß der Erfindung für mechanische Führungen ausgebildet sein könnte. Im wesentlichen geht es bei der Ausbildung der Lagervorrichtung 13 bzw. der Anordnung der Führungsmagnete 15 darum, eine geschlossene Umrandung mit mehreren sich längs erstreckenden Bereichen zu bilden. An dem Ende der Längsbereiche wiederum ist jeweils ein weiterer Führungsmagnet 15 zur Begrenzung angeordnet.

Der in dem Drehknebel 12 vorhandene entsprechende zweite Teil der Lagervorrichtung 13 weist einen zweiten Zentralmagneten 17 auf, der an einem Polkreuz 18 in dem Drehknebel 12 angeordnet ist. An den Enden der Arme des Polkreuzes 18 sind Signalmagnete 19 angeordnet. Bei dem hier gezeigten Ausführungsbeispiel weist das Polkreuz 18 fünf Arme auf. Es können jedoch bei unterschiedlichen Ausgestaltungen der Erfindung auch mehr oder weniger sein. Im wesentlichen wird durch die Anzahl der Arme des Polkreuzes 18 in Verbindung mit den entsprechenden Hall-Sensoren die Anzahl der Impulse pro Drehbewegung bestimmt.

Bei einer Drehung mit Drehrichtung R in der Ruheposition ohne Linearbewegung laufen die Signalmagnete 19 auf dem gestrichelt dargestellten Drehkreis 23. Entlang dieses Drehkreises 23 sind, wie in Fig. 1 zu erkennen ist, der Lagervorrichtung zugehörend Hall-Sensoren 21 zur Erkennung einer Drehung R angeordnet. Wie aus Fig. 1 zu erkennen ist, sind dies zwei Hall-Sensoren 21. Dieses Prinzip ist ausreichend bekannt und braucht hier nicht näher erläutert zu werden.

Des weiteren sind zwischen den Führungsmagneten 15 im äußeren Bereich der Längsbereiche weitere Hall-Sensoren 22 zur Detektierung einer Längsbewegung L angeordnet. Die Schaltsignale werden hierbei dadurch ausgelöst, dass der zweite Zentralmagnet 17 den Anziehungsbereich über dem ersten Zentralmagneten 14 verlässt. Er wird in einen der Längsbereiche eingebracht sowie darin entlang geführt. Sobald der zweite Zentralmagnet 17 über einen der Hall-Sensoren 22 kommt, wird ein entsprechendes Schaltsignal ausgelöst. Dieses Schaltsignal bedeutet die Durchführung einer Linearbewegung L.

Wie aus den Fig. 1 bis 4 zu erkennen ist, ziehen sich der erste Zentralmagnet 14 und der zweite Zentralmagnet 17 an, da sie gegensätzliche Polarität aufweisen. Dies wird durch die unterschiedliche Schraffierung verdeutlicht. Da der zweite Zentralmagnet 17 in dem Drehknebel 12 und die Führungsmagnete 15 dieselbe Polarität aufweisen, stoßen sie sich ab. Aus diesem Grunde ist eine gewisse Führung mit einer spürbaren Führungskraft des zweiten Zentralmagneten 17 über den von den Führungsmagneten 15 gebildeten Kanälen oder Längsbereichen möglich.

Zwar ist offensichtlich, dass die Führung des Drehknebels 12 sowohl bei einer Drehbewegung R als auch bei einer Linearbewegung L durch die Magnete nicht so stark ist, als dass sie nicht verlassen werden könnte. Allerdings kann durch Vorsehen entsprechender Magnete eine Führungskraft in ausreichender Größe erzeugt werden, die einem Benutzer ein deutlich spürbares Gefühl für die vorgesehenen Bewegungen gibt.

Hieraus ist erkennbar, dass anstelle einer magnetischen Führung eine mechanische Führung vorgesehen sein könnte. Es könnte anstelle des zweiten Zentralmagneten 17 eine Art Führungszapfen in Führungskulissen eingreifen, die den Längsbereichen der Führungsmagnete 15 entsprechen. Anstelle von Magnetsensoren könnten mechanische Schalter, beispielsweise Mikroschalter, verwendet werden. Ebenso könnte natürlich auch ein Führungszapfen magnetisch sein zur Verwendung von Magnetsensoren.

Aus den Fig. 3 und 4 gehen zwei unterschiedliche Ausbildungen einer erfindungsgemäßen Bedieneinheit 11 hervor.

Bei der Bedieneinheit 11 aus Fig. 3 ist unterhalb eines Glaskeramikkochfeldes 25 die Lagervorrichtung 13 gemäß Fig. 1 angebracht. Dabei kann sie an die Unterseite angeklebt oder mechanisch angedrückt sein.

Oberhalb der Lagervorrichtung 13 ist der Drehknebel 12 auf das Glaskeramikkochfeld 25 aufgesetzt. Dadurch ist einerseits sowohl eine vorbestimmte Halterung als auch Führung bei den Bewegungen R und L möglich. Des weiteren wirken die Magnete 17 und 19 durch die Glaskeramik noch in ausreichendem Maß auf die Hall-Sensoren 21 und 22, so dass die Bewegungen detektiert werden können. Bei diesem Ausführungsbeispiel kann der Drehknebel 12 abgenommen werden. Es verbleibt dann lediglich die glatte, geschlossene Oberfläche des Glaskeramikkochfeldes 25.

Von den Hall-Sensoren 21 und 22 gehen nicht dargestellte Leitungen zu einer nicht dargestellten Steuerung. Diese wertet die Signale der Hall-Sensoren als entsprechende Betätigung aus. Diese Steuerung kann nach bekannten Kriterien gestaltet werden, vorteilhaft weist sie einen Microcontroller auf.

Bei dem zweiten Ausführungsbeispiel gemäß der Fig. 4 ist die Lagervorrichtung 13 mit den Führungsmagneten 15 nicht unterhalb des geschlossenen Glaskeramikkochfeldes 25 angeordnet. Hier ist ein Haltemodul 27 vorgesehen, auf welches der Drehknebel 12 aufgesetzt wird. Im wesentlichen enthält das Haltemodul 27 einen Großteil der Einrichtung, wie sie in Fig. 3 unterhalb des Glaskeramikkochfeldes 25 vorgesehen ist, also die Lagervorrichtung 13, einen dem ersten Zentralmagneten 14 entsprechenden dritten Zentralmagnet 28 sowie Hall-Sensoren 21 und 22.

Da das Haltemodul 27 auf die geschlossene Oberfläche des Glaskeramikkochfeldes 25 aufgesetzt wird und eine Signalübertragung an eine Steuerung von Funktionseinheiten des Glaskeramikkochfeldes angeschlossen sein soll, sind weitere Einrichtungen notwendig. Diese sind zum einen der dritte Zentralmagnet 28. Mit diesem wird einerseits das Haltemodul 27 an dem ersten Zentralmagneten 14 unter dem Glaskeramikkochfeld 25 gehaltert. Des weiteren ersetzt er für den zweiten Zentralmagneten 17 im Drehknebel 12 den ersten Zentralmagnet 14 nach Fig. 3.

Des weiteren ist ein Microcontroller 30 vorgesehen, der mit den Hall-Sensoren 21 und 22 verbunden ist. In dem Microcontroller 30 kann eine Auswertung der Signale der Hall-Sensoren und somit einer Bewegung R oder L des Drehknebels stattfinden. Diese Signale sind nun an eine Steuerung unter dem Glaskeramikkochfeld 25 zu übertragen.

Dazu ist der Microcontroller 30 mit einem ersten Wandler 32 als Elektronikbaustein verbunden. Der erste Wandler 32 wiederum ist mit einem ersten Übertrager 33 bestehend aus einer ersten Spule 34 und einem ersten Ferritkern 35 verbunden.

Dem ersten Übertrager 33 in dem Haltemodul 27 ist ein zweiter Übertrager 37 unterhalb des Glaskeramikkochfeldes 25 zugeordnet. Der zweite Übertrager 37 weist eine zweite Spule 38 an einem zweiten Ferritkern 39 auf. Ein zweiter Wandler 41 ist mit dem zweiten Übertrager 37 in entsprechender Weise verbunden und gibt die empfangenen Signale an eine nicht dargestellte Steuerung weiter.

Die Wandler 32 und 41 dienen zum einen zum Umwandeln der Signale des Microcontrollers 30 für die Übertragung. Des weiteren ist es möglich, eine Energieversorgung des Haltemoduls 27 über die Übertrager 33 und 37 vorzunehmen. Dazu kann vorteilhaft eine induktive Energieübertragung implementiert werden. Damit eine Signalübertragung in einer oder auch in beide Richtungen nicht gestört wird, sollten Energieübertragung und Signalübertragung zeitversetzt, vorzugsweise während sogenannter Zeitfenster, stattfinden. Auch dies ist ausreichend aus dem Stand der Technik bekannt und braucht nicht näher erläutert zu werden.

Somit ist es auch möglich, die Einrichtungen in dem Haltemodul 27, insbesondere den Microcontroller 30, von außen mit Energie zu versorgen. Dadurch kann auf Batterien oder Akkumulatoren verzichtet werden.

Des weiteren ist es möglich, das Haltemodul 27 und/oder den Drehknebel 12 mit Anzeigemitteln oder einer Beleuchtung auszustatten. Dazu kann entweder das Haltemodul 27 direkt eine Anzeige aufweisen. Des weiteren könnte eine ebenfalls induktive Energieübertragung vom Haltemodul 27 in den Drehknebel 12 auf kontaktlose Art und Weise an dort vorhandene Anzeigen vorgesehen werden. Somit könnte der Drehknebel 12, beispielsweise an seiner nach oben weisenden Seite, eine Anzeige tragen. Mit dieser Anzeige könnten einem Benutzer verschiedene Betriebszustände und/oder Anweisungen zur Ausführung abgespeicherter Kochprogramme angezeigt werden.

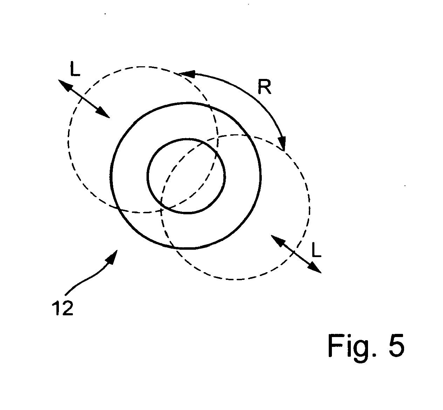

Aus Fig. 5 ist ersichtlich, wie ein Drehknebel 12 nach dem allgemeinen Erfindungsgedanken von einer Ruheposition aus entweder mit den Linearbewegungen L linear verschoben werden kann oder mit einer Radialbewegung R gedreht werden kann. Dabei ist der Drehknebel 12 gemäß dem allgemeinen Erfindungsgedanken so ausgebildet, dass er eine eingestellte Drehposition beibehält. Nach einer Linearverschiebung L jedoch kehrt er selbsttätig in die Ruhelage zurück. Dies weist auch den Vorteil auf, dass, wie aus den Fig. 1 und 2 zu ersehen ist, eine Detektierung einer Drehbewegung R vor allem in der Ruheposition, während die Magnete 14 und 17 übereinander sind, detektiert werden kann.

Eine Bedieneinheit 11 nach Fig. 4 könnte beispielsweise auch an anderen Elektrogeräten angesetzt werden zur Bedienung derselben. Hierzu müsste nicht eine gesamte Lagervorrichtung 13 an dem Elektrogerät vorgesehen sein, wie in Fig. 3. Es wird als ausreichend angesehen, gemäß Fig. 4 einen Haltemagneten 14 sowie einen Übertrager 37 vorzusehen. Es ist allgemein auch denkbar, die Signalübertragung mit einer Funkstrecke oder elektromagnetischen Wellen, beispielsweise IR-Strahlung, vorzunehmen. In diesem Fall werden die Übertrager 33 und 37 durch entsprechende Übertragungsmittel ersetzt. Dabei ist dann allerdings in der Regel keine Energieübertragung mehr möglich.

## Patentansprüche

1. Bedienvorrichtung für ein Elektrogerät, vorzugsweise ein Elektrowärmegerät, wobei
- die Bedienvorrichtung eine Bedieneinheit (11) mit einem Drehknebel (12) aufweist,
- die Bedienvorrichtung eine Lagervorrichtung (13) für den Drehknebel (12) aufweist,
- der Drehknebel (12) drehbewegbar an der Lagervorrichtung (13) gelagert ist,
- Signalmittel vorgesehen sind zur Erzeugung von Signalen abhängig von einer Stellung und/oder Stellungsänderung des Drehknebels (12),
- die Bedienvorrichtung eine Steuerung (30) zur Verarbeitung der Signale zur Beeinflussung des Elektrogeräts aufweist, **daduch gekennzeichnet, dass**
- der Drehknebel (12) zusätzlich mit einer Linearbewegung (L) in mindestens eine Richtung bewegbar gelagert ist und
- die Signalmittel auch für die Erkennung der Linearbewegung (L) des Drehknebels (12) ausgebildet sind.

2. Bedienvorrichtung nach Anspruch 1, **dadurch gekennzeichnet, dass** die Bedieneinheit (11) abnehmbar an einer Abdeckung (25) des Elektrogeräts befestigbar ist mittels einer Haltekraft, wobei die Haltekraft vorzugsweise nicht kontaktierend ist, insbesondere Haltemagnete (14, 17, 28) in der Lagervorrichtung (13) und/oder an der Abdeckung (25) des Elektrogerätes aufweist.

3. Bedienvorrichtung nach Anspruch 1 oder 2, **dadurch gekennzeichnet, dass** der Drehknebel (12) um eine Drehachse drehbar (R) gelagert ist, wobei die Linearbewegung (L) im wesentlichen radial dazu verläuft, wobei vorzugsweise die Lagervorrichtung (13) derart ausgebildet ist, dass der Drehknebel (12) nach Durchführen einer Linearbewegung (L) selbsttätig rückstellbar ist.

4. Bedienvorrichtung nach einem der vorhergehenden Ansprüche, **dadurch gekennzeichnet, dass** eine Linearbewegung (L) im wesentlichen entlang einer Geraden erfolgt, wobei vorzugsweise die Gerade durch die Drehachse des Drehknebels (12) läuft.

5. Bedienvorrichtung nach einem der vorhergehenden Ansprüche, **dadurch gekennzeichnet, dass** die Lagervorrichtung (13) im wesentlichen separat von der Abdeckung (25) ausgebildet ist und mit dem Drehknebel (12) die Baueinheit der Bedieneinheit (11) bildet, wobei vorzugsweise die Lagervorrichtung eine Grundplatte (27) zur Anlage an der Abdeckung aufweist.

6. Bedienvorrichtung nach einem der vorhergehenden Ansprüche, **gekennzeichnet durch** eine Linearbewegung (L) des Drehknebels (12) gegenüber einer Grundplatte (27) der Lagervorrichtung (13).

7. Bedienvorrichtung nach einem der vorhergehenden Ansprüche, **gekennzeichnet durch** eine Linearbewegung von Drehknebel (12) und Grundplatte der Lagervorrichtung (13) gegenüber der Abdeckung.

8. Bedienvorrichtung nach einem der vorhergehenden Ansprüche, **dadurch gekennzeichnet, dass** eine Führung der Linearbewegung (L) im wesentlichen berührungsfrei durch Magnetkraft (15) erfolgt.

9. Bedienvorrichtung nach einem der Ansprüche 1 bis 7, **dadurch gekennzeichnet, dass** eine Führung der Linearbewegung (L) durch mechanische Führungsmittel erfolgt.

10. Bedienvorrichtung nach einem der vorhergehenden Ansprüche, **dadurch gekennzeichnet, dass** ein Teil der Signalmittel (17, 19) im Drehknebel (12) vorgesehen ist, insbesondere die eine funktionale Hälfte der Signalmittel, wobei vorzugsweise Signalmittel, insbesondere die andere funktionale Hälfte der Signalmittel (21, 22), in einer Grundplatte (27) der Lagervorrichtung (13) angeordnet sind.

11. Bedienvorrichtung nach Anspruch 10, **dadurch gekennzeichnet, dass** ein Teil der Signalmittel (21, 22) unterhalb der Abdeckung (25) daran befestigt angeordnet ist.

12. Bedienvorrichtung nach einem der vorhergehenden Ansprüche, **dadurch gekennzeichnet, dass** in der Bedieneinheit (11) Anzeigemittel vorgesehen sind, vorzugsweise mit Leuchtmitteln versehen.

13. Bedienvorrichtung nach einem der vorhergehenden Ansprüche, **dadurch gekennzeichnet, dass** die Signalmittel (17, 19; 21, 22) Stellungsbestimmungsmittel aufweisen zur Bestimmung der Stellung, vorzugsweise auch der Drehwinkellage, des Drehknebels (12) gegenüber einem Referenzpunkt der Abdeckung (25), wobei vorzugsweise die Stellungsbestimmungsmittel mindestens einen Signalmagnet (17, 19) und mindestens einen Magnetfeldsensor (21, 22), insbesondere mehrere Magnetfeldsensoren, aufweisen.

14. Bedienvorrichtung nach einem der vorhergehenden Ansprüche, **dadurch gekennzeichnet, dass** eine Linearbewegung (L) bis zur Auslösung eines Signals und/oder bis an einen Anschlag kürzer ist als die Erstreckung des Drehknebels (12) in dieser Richtung.

## Claims

1. Operating device for an electrical appliance preferably an electrical heating device, wherein
- the operating device has an operating unit (11) with a rotary toggle (12),
- the operating device has a bearing device (13) for the rotary toggle (12),
- the rotary toggle (12) is mounted so as to rotate on the bearing device (13),
- signalling means are provided for generating signals as a function of a position and/or position change of the rotary toggle (12),
- the operating device has a control mechanism (30) for processing the signals for influencing the electrical appliance, **characterized in that**
- the rotary toggle (12) is additionally mounted so as to have a linear movement (L) in at least one direction and
- the signalling means are also constructed for detecting the linear movement (L) of the rotary toggle (12).

2. Operating device according to claim 1, **characterized in that** the operating unit (11) can be removably fixed to a cover (25) of the electrical appliance by means of a holding power, which is preferably non-contacting and in particular has holding magnets (14, 17, 28) in the bearing device (13) and/or on the electrical appliance cover (25).

3. Operating device according to claim 1 or 2, **characterized in that** the rotary toggle (12) is mounted so as to rotate (R) about a rotation axis and the linear movement (L) takes place substantially radially thereto and preferably the bearing device (13) is constructed in such a way that, after performing a linear movement (L), the rotary toggle (12) can be automatically reset.

4. Operating device according to one of the preceding claims, **characterized in that** a linear movement (L) essentially takes place along a straight line, which preferably passes through the rotation axis of the rotary toggle (12).

5. Operating device according to one of the preceding claims, **characterized in that** the bearing device (13) is essentially constructed separately from the cover (25) and forms with the rotary toggle (12) the constructional unit of the operating unit (11) and preferably the bearing device (13) has a. base plate (27) for engaging on the cover (25).

6. Operating device according to one of the preceding claims, **characterized in that** there is a linear movement (L) of the rotary toggle (12) with respect to a base plate (27) of the bearing device (13).

7. Operating device according to one of the preceding claims, **characterized in that** there is a linear movement of the rotary toggle (12) and the base plate of the bearing device (13) with respect to the cover.

8. Operating device according to one of the preceding claims, **characterized in that** the guidance of the linear movement (L) takes place essentially in non-contacting manner through magnetic force (15).

9. Operating device according to one of the claims 1 to 7, **characterized in that** the linear movement (L) is guided by mechanical guidance means.

10. Operating device according to one of the preceding claims, **characterized in that** part of the signalling means (17, 19) is provided in the rotary toggle (12) and in particular one functional half of the signalling means, particularly the other functional half of the signalling means (21, 22) are located in a base plate (27) of the bearing device (13).

11. Operating device according to claim 10, **characterized in that** part of the signalling means (21, 22) is positioned below and fixed to the cover (25).

12. Operating device according to one of the preceding claims, **characterized in that** display means, preferably with lighting means are provided in the operating unit (11).

13. Operating device according to one of the preceding claims, **characterized in that** the signalling means (17, 19; 21, 22) have position determination means for determining the position and preferably also the rotation angle position of the rotary toggle (12) with respect to a reference point of the cover (25) and preferably the position determination means have at least one signalling magnet (17, 19) and at least one magnetic field sensor (21, 22), particularly several magnetic field sensors.

14. Operating device according to one of the preceding claims, **characterized in that** a linear movement (L) up to the release of a signal and/or up to a stop member is shorter than the extension of the rotary toggle (12) in this direction.

## Revendications

1. Dispositif de commande pour un appareil électrique, de préférence pour un appareil électrique de chauffage, où
- le dispositif de commande présente une unité de commande (11) avec une manette rotative (12),
- le dispositif de commande présente un dispositif de logement (13) pour la manette rotative (12),
- la manette rotative (12) est logée sur le dispositif de logement (13) de manière à permettre un mouvement rotatif ,
- on prévoit des moyens de signalisation pour émettre des signaux en fonction d'une position et/ou d'un changement de position de la manette rotative (12),
- le dispositif de commande présente un système de commande (30) pour l'évaluation des signaux qui doivent influencer l'appareil électrique, **caractérisé en ce que**
- la manette rotative (12) est logée de manière à permettre en outre un mouvement linéaire (L) dans au moins une autre direction et où
- les moyens de signalisation sont réalisés de manière à pouvoir également capter le mouvement linéaire (L) de la manette rotative (12).

2. Dispositif de commande d'après la revendication 1, **caractérisé en ce que** l'unité de commande (11) peut être fixée de manière amovible sur un recouvrement (25) de l'appareil électrique au moyen d'une force de retenue, sachant que la force de retenue n'établie de préférence pas de contact, qu'elle présente notamment des aimants de retenue (14, 17, 28) dans le dispositif de logement (13) et/ou auprès du recouvrement (25) de l'appareil électrique.

3. Dispositif de commande d'après la revendication 1 ou 2, **caractérisé en ce que** la manette rotative (12) est logée de manière rotative (R) autour d'un axe de rotation, sachant que le mouvement linéaire (L) a lieu essentiellement en direction radiale par rapport à ceci, sachant qu'il est préférable que le dispositif de logement (13) soit réalisé de manière que la manette rotative (12) soit remise en état initial de façon automatique après le mouvement linéaire (L).

4. Dispositif de commande d'après une des revendications précédentes, **caractérisé en ce qu'**un mouvement linéaire (L) a lieu essentiellement le long d'une droite, où la droite s'étend de préférence à travers l'axe de rotation de la manette rotative (12).

5. Dispositif de commande d'après une des revendications précédentes, **caractérisé en ce que** le dispositif de logement (13) est réalisé de manière essentiellement distincte du recouvrement (25) et que, avec la manette rotative (12), il forme l'unité de construction nommée unité de commande (11), sachant que de préférence le dispositif de logement présente une plaque de base (27) pour la contiguïté au recouvrement.

6. Dispositif de commande d'après une des revendications précédentes, **caractérisé par** un mouvement linéaire (L) de la manette rotative (12) par rapport à une plaque de base (27) du dispositif de logement (13).

7. Dispositif de commande d'après une des revendications précédentes, **caractérisé par** un mouvement linéaire de la manette rotative (12) et de la plaque de base du dispositif de logement (13) par rapport au recouvrement.

8. Dispositif de commande d'après une des revendications précédentes, **caractérisé en ce qu'**un guidage du mouvement linéaire (L) est effectué essentiellement sans contact direct, par une force magnétique (15).

9. Dispositif de commande d'après une des revendications de 1 à 7, **caractérisé en ce qu'**un guidage du mouvement linéaire (L) est effectué par des moyens de guidage mécaniques.

10. Dispositif de commande d'après une des revendications précédentes, **caractérisé en ce qu'**une partie des moyens de signalisation (17, 19) est prévue dans la manette rotative (12), notamment l'une des moitiés fonctionnelles des moyens de signalisation, où de préférence des moyens de signalisation, notamment l'autre moitié fonctionnelle des moyens de signalisation (21, 22), sont disposés dans une plaque de base (27) du dispositif de logement (13).

11. Dispositif de commande d'après la revendication 10, **caractérisé en ce qu'**une partie des moyens de signalisation (21, 22) est disposée au-dessous du recouvrement (25) en y étant fixée.

12. Dispositif de commande d'après une des revendications précédentes, **caractérisé en ce que** dans l'unité de commande (11) on prévoit des moyens de visualisation, de préférence avec des agents lumineux.

13. Dispositif de commande d'après une des revendications précédentes, **caractérisé en ce que** les moyens de signalisation (17, 19 ; 21, 22) présentent des moyens d'évaluation de position pour évaluer la position, de préférence aussi la position angulaire de la manette rotative (12) par rapport à un point de référence du recouvrement (25), sachant que de préférence les moyens d'évaluation de position présentent au moins un aimant de signalisation (17, 19) et au moins un capteur de champ magnétique (21, 22), notamment plusieurs capteurs de champ magnétique.

14. Dispositif de commande d'après une des revendications précédentes, **caractérisé en ce qu'**un mouvement linéaire (L) jusqu'à un déclenchement d'un signal et/ou jusqu'à un arrêt est plus court que l'étendue de la manette rotative (12) dans cette direction.
